(19) Europäisches Patentamt
European Patent Office
Office européen des brevets

(11) Numéro de publication: **0 028 994**
**B1**

(12) **FASCICULE DE BREVET EUROPEEN**

(45) Date de publication du fascicule du brevet: **29.08.84**

(21) Numéro de dépôt: **80420119.2**

(22) Date de dépôt: **05.11.80**

(51) Int. Cl.$^3$: **H 01 L 23/28,** H 01 L 23/30, H 01 L 21/312, H 01 C 1/034, H 01 G 1/02, C 08 G 73/12

# (54) Compositions et procédé d'encapsulation de composants électroniques à l'aide d'une matière moulable à base d'un prépolymère thermodurcissable.

(30) Priorité: **09.11.79 FR 7928145**

(43) Date de publication de la demande:
**20.05.81 Bulletin 81/20**

(45) Mention de la délivrance du brevet:
**29.08.84 Bulletin 84/35**

(84) Etats contractants désignés:
**BE CH DE FR GB IT LI LU NL SE**

(58) Documents cités:
**EP-A-0 022 049**
**FR-A-2 046 162**
**FR-A-2 392 495**
**US-A-3 729 814**
**US-A-3 738 969**
**US-A-3 996 203**
**US-A-4 064 192**

(73) Titulaire: **RHONE-POULENC SPECIALITES CHIMIQUES**
**"Les Miroirs" 18, Avenue d'Alsace**
**F-92400 Courbevoie (FR)**

(72) Inventeur: **Laurent, Serge**
**40, rue Alsace-Lorraine**
**F-69500 Bron (FR)**

(74) Mandataire: **Perret, Michel et al**
**RHONE-POULENC RECHERCHES Service Brevets Chimie et Polymères Centre de Recherches de Saint-Fons 85, Avenue des Frères Perret B.P. 62**
**F-69192 St-Fons Cédex (FR)**

**EP 0 028 994 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

## Description

La présente invention concerne des compositions et un procédé d'encapsulation d'au moins un composant électronique à l'aide d'une matière moulable à base d'un prépolymère thermodurcissable. Plus précisément la présente invention a trait à un procédé d'encapsulation par mise en oeuvre des méthodes de moulage par transfert basse pression et par injection.

Par "encapsulation" on désigne un procédé dans lequel le composant électronique est:

soit totalement recouvert par la matière à mouler qui joue alors le rôle d'enveloppe ou de boitier;

soit, lorsque le composant est en contact direct par une de ses surfaces avec un support, partiellement recouvert par la matière à mouler qui joue alors le rôle d'un capot pour les surfaces qui ne sont pas en contact avec le support.

Le procédé d'encapsulation par transfert est une méthode d'enrobage bien connue et très répandue car elle permet une productivité élevée et par conséquent la réduction des coûts de production. Ce procédé consiste à la mise en place des composants à encapsuler dans les cavités d'un moule chauffé, à l'introduction de la matière à mouler dans les cavités à l'aide d'un piston. Afin de ne pas dégrader les composants électroniques il est recommandé d'opérer le moulage à une température généralement comprise entre 130° et 200°C et sous une pression qui se situe généralement au-dessous de 80 kg/cm2. Pour des raisons de productivité, il est avantageux que le cycle de moulage puisse se dérouler en un temps court qui n'excède pas 3 minutes.

Le moulage par injection est une méthode voisine également connue dans laquelle la matière à mouler amenée à l'état fondu est poussée directement dans les cavités à l'aide d'une vis extrudeuse.

Ces méthodes de moulage requièrent l'emploi d'une matière à mouler qui doit présenter, dans les conditions de température qui président au moulage, une viscosité et un temps de gélification qui se situent à des valeurs bien déterminées. En effet une haute viscosité peut endommager les composants électroniques alors qu'une trop faible viscosité peut être la cause de porosité.

Le temps de gélification doit correspondre très précisément à des valeurs qui permettent d'effectuer sans difficulté chaque cycle de moulage dans la courte période mentionnée ci-avant. Un temps de gélification trop court pourra entrainer un remplissage incomplet des cavités alors qu'une gélification trop longue pourra être à l'origine d'un écoulement de la matière à mouler entre les plans de joint de moule. Ces effets de bavures nécéssiteront un travail complètementaire de nettoyage coûteux et délicat. Un bon équilibre des paramètres de viscosité et temps de gélification est donc essentiel pour une production économique.

D'autres caractéristiques sont exigées encore pour la matière à mouler. Elles résident dans les points suivants:

l'ininflammabilité et la non toxicité;

la pureté chimique;

une tenue thermique élevée alliée à de bonnes propriétés électriques et une excellente stabilité dimensionnelle;

une bonne résistance mécanique;

une bonne adhérence sur divers supports, notamment vis à vis des substrats métalliques (par exemple: les semelles métalliques avec lesquelles les composants électroniques peuvent être en contact; les fils de connexion).

Les matières à mouler actuellement commercialisées sont essentiellement des résines époxydes et des résines silicones. Mais bien que leurs caractéristiques en matière de viscosité et de temps de gélification puissent être bien adaptées aux conditions de moulage indiquées ci-avant, ces résines ne satisfont pas encore totalement sur certains points les fabricants de composants électroniques, notamment les fabricants de composants actifs de puissance tels que par exemple les diodes, les transistors, les circuits intégrés et les fabricants de composants passifs tels que par exemple les bobinages, les redresseurs, les ferrites, les condensateurs, les résistances, les connecteurs. Un problème important qu'il convient habituellement de résoudre dans le domaine de l'encapsulation des composants de puissance, qui sont, comme on le sait, des matériaux en général assez sensibles à la pollution atmosphérique, réside dans la nécessité de pouvoir disposer d'une matière à mouler qui présente un très bon niveau de propriétés en matière de tenue thermique et de résistance mécanique en flexion; ces propriétés conditionnent en effet à la fois l'étanchéité des boîtiers ou capots et leur adhérence sur des substrats métalliques.

Les résines époxydes qui possèdent des coefficients de dilatation élevés sont à la limite de leurs possibilités thermiques et les silicones manquent de propriétés mécaniques en flexion, fissurent et adhèrent mal aux substrats métalliques.

Le brevet US—A—3 996 203 enseigne un procédé d'obtention de polyimides en solution à partir de diamines et d'anhydrides. Ces polymères qui ont d'excellentes propriétés physiques, mécaniques, chimiques, électriques et thermiques peuvent être utilisées pour de très nombreux et très variés usages dont l'encapsulation. Toutefois l'emploi du polymère selon ce brevet ne permet pas de résoudre les nombreux problèmes liés à la mise en oeuvre particulière de l'encapsulation de composants électroniques.

Il a maintenant été trouvé et c'est ce qui constitue l'objet de la présente invention, des

compositions et un procédé d'encapsulation de composants électroniques qui met en oeuvre une matière à mouler répondant parfaitement aux demandes des utilisateurs.

Plus spécifiquement, la présente invention se rapporte à des compositions pour l'encapsulation de composants électroniques en utilisant les méthodes de moulage par transfert ou par injection constituées à partir:

(a) un prépolymère de bis-imide et de polyamine obtenu par chauffage de N,N'-4,4'-diphénylméthane bis-maléimide et du diamino-4,4'-diphénylméthane et présentant un point de ramollissement compris entre 50 et 120°C.

(b) un initiateur de polymérisation radicalaire et

(c) des charges,

caractérisées en ce que l'évolution du module de la raideur complexe dudit prépolymère en fonction du temps, lorsqu'il est soumis à une opération de réticulation à 170°C, est telle qu'au bout de 5 minutes, ledit module est compris entre $3.10^4$ et $10^7$ N/m et qu'au bout de 15 minutes, il s'élève à des valeurs comprises entre $3.10^5$ et $3.10^7$ N/m, et que l'initiateur de polymérisation radicalaire est mis en oeuvre sous forme de suspension ou de solution dans une huile organopolysiloxanique ou dans une association comprenant une huile et une résine organopolysiloxanique.

On appelle point de ramollissement, la température approximative à laquelle une baguette de verre peut s'enfoncer facilement de quelques millimètres dans le prépolymère.

Le module de la raideur complexe est une caractéristique dynamique du prépolymère qui est mesurée à l'aide du viscoélasticimètre connu dans le commerce sous le nom METRAVIB. Le principe de fonctionnement de cet appareil consiste à soumettre un échantillon du prépolymère à une déformation sinusoïdale d'amplitude réglable et à déterminer la force transmise à l'échantillon. La valeur du module de la raideur complexe (exprimée en Newton/mètre) est élaborée directement par l'appareil à partir des mesures de la force transmise à l'échantillon et de l'amplitude du mouvement de deformation. Plus le degré de réticulation du prépolymère est élevé, plus la force transmise est forte et plus le corps est raide. L'évolution de la raideur en fonction du temps permet donc de caractériser le prépolymère du point de vue de sa cinétique de réticulation de l'état liquide à l'état solide. La cellule de mesure utilisée est celle habituellement destinée à l'étude des liquides. Pour déterminer la valeur du module de la raideur complexe on doit prendre soin à ce que la température de la cellule soit parfaitement régulée de manière à ce qu'elle ne s'écarte pas de plus de 2°C ou 3°C de part et d'autre de la température de réticulation choisie.

On utilise dans l'invention un prépolymère issu du N,N'-4,4'-diphénylméthane bis-maléimide et du diamino-4,4'-diphénylméthane.

La préparation du prépolymère (a) qui répond aux caractéristiques mentionnées ci-avant peut s'effectuer de différentes manières. On citera notamment la manière qui consiste à chauffer, entre 50° et 200°C, le bis-imide et la polyamine en opérant en présence d'un mono- ou polyacide oxygéné d'origine organique dont l'une au moins des fonctions acide possède une constante d'ionisation dans l'eau, pKa, inférieure à 5; on peut opérer également en présence d'un mélange de deux ou de plus de deux de ces acides. Il peut s'agir d-acides mono- ou polycarboxyliques, ceux-ci pouvant être de structure simple ou posséder des groupements qui ne perturbent pas la réaction entre le bis-imide et la polyamine. Comme acide, on mentionnera:

l'acide acétique;
l'acide monochloro-acétique;
l'acide dichloro-acétique;
l'acide fumarique;
l'acide maléique;
l'acide trimellique;
l'acide phtalique (ortho, méta ou para);
un acide bis-maléamique de formule:

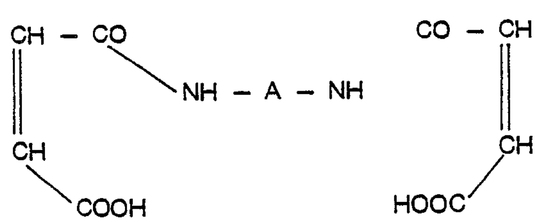

(I)

dans laquelle le symbole A peut représenter un radical alkylène, linéaire ou ramifié, ayant moins de 13 atomes de carbone; un radical phénylène; un radical cyclohexylène; un radical ayant l'une des formules suivantes:

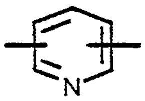 , 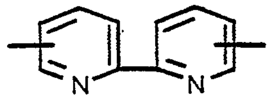 , 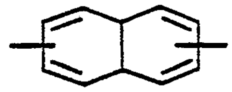 , 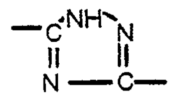 ,

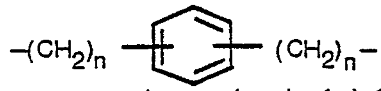

où n représente un nombre entier de 1 à 3. Le symbole A peut également comprendre plusieurs radicaux phénylène ou cyclohexylène reliés entre eux par un lien valentiel simple ou un atome ou groupement inerte tel que: —O—, —S—, un groupement alkylène ayant de 1 à 3 atomes de carbone, —CO—, —$SO_2$—, —$NR_1$—, —N = N—, —CONH—, —COO—, —P(O)$R_1$—, —CONH—X—NHCO—,

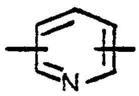 , 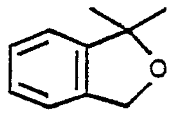 , 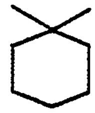 , 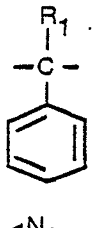 , 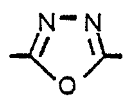 , 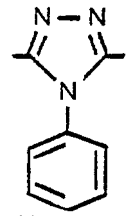 ,

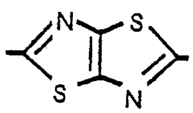 , 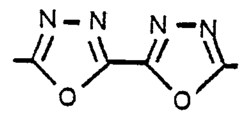 , 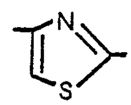 , 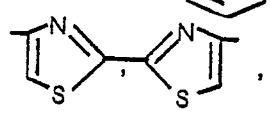 ,

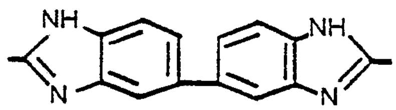 ,

où $R_1$ représente un atome d'hydrogène, un radical alkyle ayant de 1 à 4 atomes de carbone, un radical phényle ou cyclohexyle et X représente un radical alkylène ayant moins de 13 atomes de carbone.

un acide monomaléamique de formule:

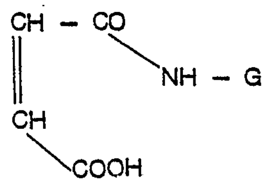 (II)

dans laquelle le symbole G représente: un radical alkyle, linéaire ou ramifié, renfermant de 1 à 10 atomes de carbone; un radical aryle comme phényle, éventuellement substitué par un ou plusieurs groupes alkyle comme méthyle; ou un radical de formule —A—$NH_2$.

A titre d'exemples spécifiques d'acides de formule (I) et (II) on peut citer:

— l'acide N,N'-éthylène bis-maléamique,
— l'acide N,N'-hexaméthylène bis-maléamique,
— l'acide N,N'-métaphénylène bis-maléamique,
— l'acide N,N'-paraphénylène bis-maléamique,
— l'acide N,N'-4,4'-diphénylméthane bis-maléamique,
— l'acide N,N'-4,4'-diphényléther bis-maléamique,
— l'acide N,N'-4,4'-diphénylsulfone bis-maléamique,
— l'acide N,N'-4,4'-dicyclohexylméthane bis-maléamique,
— l'acide N,N'-4,4'-diphénylsulfure bis-maléamique,
— l'acide N,N'-4,4'-diphénylène bis-maléamique,
— l'acide N,N'-4,4'-benzophénone bis-maléamique,
— l'acide N,N'-4,4'-azobenzène bis-maléamique,
— l'acide N,N'-4,4'-triphénylméthane bis-maléamique,
— l'acide N-butyl monomaléamique,
— l'acide N-phényl monomaléamique,
— l'acide N-tolyl monomaléamique,
— l'acide N-4-(amino-4')diphénylméthane monomaléamique.

Les acides maléamiques précités peuvent être préparés selon les procédés connus, et, à ce sujet, on peut par exemple se reporter à l'ouvrage de L.A. FLETT et W.H. GARDNER, intitulé "Maleic Anhydride Derivatives" (1952, John WILEY and Sons, Inc., New-York), pages 104 et 105. Les acides monomaléamiques sont aisément obtenus par introduction d'anhydride maléique dans un excès molaire d'amine G—$NH_2$ ou A—$(NH_2)_2$ en solution dans un hydrocarbure tel que benzène, heptane ou cyclohexane.

Quand on choisit de mettre en oeuvre un prépolymère issu du N,N'-4,4'-diphénylméthane bis-maléimide et du diamino-4,4' diphénylméthane, les acides préférés sont les acides maléique et/ou N,N'-4,4'-diphénylméthane bis-maléamique et/ou N-4-(amino-4') diphénylméthane monomaléamique. Le mélange de ces acides convient tout particulièrement bien.

On emploie généralement des quantités pondérales d'acide ou de mélange d'acides qui représentent de 0,5 à 5% par rapport au poids du bis-imide (I) mis en oeuvre. Des quantités comprises entre 1% et 4% conviennent tout particulièrement bien.

La préparation du prépolymère peut être effectuée en masse en chauffant le mélange réactionnel préalablement soumis à un mélange intime à l'aide des techniques conventionnelles.

La préparation du prépolymère peut être effectuée aussi au sein d'un solvant polaire tel que crésol, diméthylformamide, N-méthyl-pyrrolidone, diméthylacétamide, chlorobenzène. Il doit être entendu que l'on peut utiliser un bis-imide ou bien un mélange de plusieurs bis-imides. De même, il va de soi que par le terme polyamine, on entend également désigner des mélanges de polyamines de même fonctionnalité, ou bien encore des mélanges de polyamines dont au moins deux possèdent des fonctionnalités différentes. On utilise généralement une ou plusieurs diamines biprimaires éventuellement en association avec une ou plusieurs polyamines de fonctionnalité supérieure et pouvant représenter, en poids, jusqu'à 50% du poids des diamines engagées. On choisit de préférence les quantités de réactifs telles que l'on ait de 0,6 à 2,5 moles de bis-imide par groupement molaire $NH_2$ apporté par la polyamine.

Le constituant (b) de la matière à mouler utilisé dans le procédé selon l'invention consiste en un initiateur radicalaire connu. L'initiateur peut être un composé peroxydique, tel que le peroxyde de dilauroyle, le peroxyde de dicumyle, le peroxyde de ditertiobutyle, le peroxyde mixte de t.butyle et de cumyle, le diméthyl-2,5 di(t.butylperoxy)-2,5 hexyne-3. Il peut s'agir aussi d'un composé diazo tel que l'$\alpha,\alpha$,-azo-bis-isobutyronitrile. On utilise de préférence un peroxyde organique. La quantité d'initiateur représente de préférence 0,5 à 5% du poids de prépolymère (a).

Il convient de noter que l'initiateur radicalaire peut être incorporé dans la matière à mouler, et il s'agit là d'une mesure préférentielle, sous forme de mélange avec une huile organopolysiloxanique ou avec une asociation comprenant une huile et une résine organopolysiloxanique (ce mélange a généralement l'aspect d'une suspension). Les huiles et résines qui conviennent sont notamment celles décrites dans le brevet français No 2 205 552. On notera que convient tout particulièrement bien l'association d'huile organopolysiloxanique de viscosité comprise entre 10 et 10 000 cPo à 20° avec une résine méthylpolysiloxanique composée essentiallement de motifs triméthylsiloxy et de motifs $SiO_2$, le rapport nombre de groupement méthyl/nombre d'atome de silicium étant généralement compris entre 0,8/1 et 1,5/1 et de préférence entre 1,1/1 et 1,3/1. Ces résines peuvent être préparées par exemple par cohydrolyse de $(CH_3)_3$ SiL et de $SiL_4$, formules dans lesquelles le symbole L représente un groupement hydrolysable. Lorsqu'on utilise une association comprenant l'huile et la résine définies ci-avant, la proportion de résine est habituellement inférieure à 50% du poids du mélange. La proportion d'huile ou d'association huile/résine organopolysiloxanique représente généralement 0,5 à 3% du poids du prépolymère (a).

Dans ce qui suit on désignera par l'expression "composé organosilicique" soit l'huile organopolysiloxanique soit l'association huile/résine organopolysiloxanique.

Le constituant (c) de la matière à mouler est formé par des charges. La quantité de charges utilisées peut atteindre 80% du poids du mélange constituant la matière à mouler. Ces charges qui peuvent être fibreuses ou pulvérulentes, sont notamment celles qui sont décrites dans le brevet français No 2 029 114.

Plus généralement, on utilise des charges minérales de fine granulométrie telles que: des particules de mica, de talc, d'hydrosilicate de calcium du type Wollastonite, de carbonates de calcium (calcite) et de magnésium (dolomie), d'alumine, d'hydrate d'alumine, de kaolin, de silice; ou bien des microbilles de verre ou encore des fibres d'amiante ou de verre. Généralement la granulométrie des charges pulvérulentes est comprise entre 0,1 et 200 $\mu$; la longueur des fibres est habituellement inférieure à 5 mm. La proportion de charges est de préférence comprise entre 10 et 75%.

Comme charges qui conviennent tout particulièrement bien, on citera: la silice fondue et broyée dont la granulométrie est inférieure ou égale à 100 $\mu$; le carbonate de calcium (calcite) ou un mélange de carbonate de calcium avec un faible taux de dolomie dont la granulométrie est inférieure ou égale à 100 $\mu$; des mélanges de pareille silice ou de pareil(s) carbonate(s) avec des fibres de verre dont la longueur est inférieure ou égale à 0,8 mm, la proportion de silice ou de carbonate(s) dans lesdits mélanges pouvant varier entre 20% et 80% en poids.

Il peut être avantageux d'incorporer encore dans la matière à mouler un agent permettant d'améliorer le démoulage des articles encapsulés. C'est le cas notamment lorsque les cadences de production sont très élevées. Comme agent de démoulage on citera notamment les cires, naturelles ou synthétiques, les stéarates métalliques, l'huile de ricin. Des mélanges d'agents de démoulage peuvent être utilisés. La proportion d'agent de démoulage, quand on choisit d'en utiliser un, représente au plus 4% du poids de la matière à mouler.

La préparation de la matière à mouler utilisable dans le procédé selon la présente invention peut s'effectuer de différentes manières. Il est ainsi possible d'incorporer en même temps dans le prépolymère à l'état solide l'initiateur radicalaire (éventuellement en mélange avec le composé

organosilicique précité), les charges et éventuellement l'agent de démoulage, puis d'homogénéiser l'ensemble par simple malaxage. Il doit être entendu que l'incorporation des charges peut être réalisée soit avant soit après l'introduction de l'initiateur radicalaire. Dans la première éventualité, on peut soit mélanger les charges au prépolymère préparé séparément, soit effectuer la prépolymérisation du bis-imide et de la polyamine en présence desdites charges.

Une manière préférée d'opérer consiste à faire appel à un initiateur radicalaire en suspension dans une huile ou une association huile/résine organopolysiloxanique et à enchainer les étapes suivantes:

en opérant dans un mélangeur à poudre classique, on mélange le prépolymère avec la suspension initiateur/composé organosilicique en coulant ladite suspension sur le prépolymère à l'état solide ou sur le mélange, préparé préalablement, du prépolymère et de l'agent de démoulage, puis on incorpore les charges à l'ensemble de la masse obtenue;

on procède ensuite à l'homogénéisation de la matière à mouler en opérant dans un malaxeur à vis extrudeuse. Des appareils de ce genre peuvent comporter une ou plusieurs vis sans fin et être équipés d'un système permettant d'effectuer un chauffage contrôlé de la zone de malaxage. Le chauffage peut être exercé de manière uniforme sur toute la longueur de la zone de malaxage, mais on peut également disposer plusieurs zones de chauffages contigües assurant à la zone de malaxage une température par exemple croissante dans le sens de progression de la matière. Un chauffage de la zone de malaxage à une température comprise entre 50° et 120°C et un temps de séjour de la matière à mouler dans ladite zone compris entre 2 et 10 minutes conviennent bien en général.

Pour des raisons de commodité, on peut mettre en oeuvre la suspension initiateur/composé organosilicique sous forme d'un mélange, préparé séparément, de ladite suspension avec un agent de dilution tel que par exemple une fraction de distillation du pétrole de bas point d'ébullition comme le white spirit. La proportion d'agent de dilution peut atteindre 50% du poids de la suspension initiateur/composé organosilicique. Cette mesure permet d'obtenir une solution d'initiateur dans le composé organosilicique.

Après avoir été homogénéisée, la matière à mouler est soumise en général à une opération de broyage de manière à avoir une granulométrie comprise entre 30 et 6 000 $\mu$m environ.

La matière qui vient d'être décrite peut être moulée dans des conditions douces, c'est-à-dire à des températures comprises entre 130° et 200°C et sous des pressions de transfert comprises entre 20 et 60 kg/cm2. Elle permet des cadences de moulage élevées et n'entraine qu'un minimum d'effets de bavures.

Lors de l'opération d'encapsulation, qui s'effectue à une température supérieure au point de ramollissement du prépolymère et au point de décomposition de l'initiateur, le prépolymère se transforme en résine tridimensionnelle, conférant aux articles composites obtenus des propriétés mécaniques et une stabilité thermique élevées et supérieurs à celles enregistrées jusqu'ici avec les résines époxydes ou silicones. Après moulage, ces articles peuvent subir une post-cuisson de 4 à 48 h environ à une température pouvant atteindre 250°C.

La présente invention sera plus aisément comprise à l'aide de l'exemple suivant donné à titre non limitatif.

## Exemple

A/ *Préparation de la matière à mouler:*

1. *Matériaux:*

1.1. Prépolymère:

Il est préparé par chauffage en masse à 150°C d'un mélange de N,N'-4,4'-diphénylméthane bis-maléimide, de diamino-4,4'-diphénylméthane, d'acide maléique, d'acide N,N'-4,4'-diphénylméthane bis-maléamique et d'acide N-4-(amino-4')diphénylméthane monomaléamique. Le rapport molaire bis-imide/diamine est égal à 2,5. La quantité totale d'acides présents représente 2,3% du poids du bis-imide engagé et elle se répartit comme suivant: acide maléique 0,65%; acide bis-maléamique 1,2%; acide monomaléamique 0,45%. Ce prépolymère se ramollit à 70°C. Lorsque l'on réticule ce prépolymère à 170°C, on trouve que sa raideur, au bout de 5 minutes est de $3{,}6.10^5$ N/m et, au bout de 15 minutes, de $1{,}5.10^7$ N/m.

1.2. Mélange démoulant:

Il est préparé par mélange:

de deux agents de démoulage:

— huile de ricin (1 partie en poids)

— et stéarate de zinc (1 partie en poids)

avec du prépolymère (8 parties en poids).

Le mélange est fait par fusion de l'ensemble en étuve pendant 30 minutes, puis broyage.

1.3. Solution d'initiateur radicalaire:

Elle est préparée par mélange à température ambiante (20° à 25°C) des ingrédients suivants:

peroxyde de dicumyle (0,5 partie en poids)

peroxyde de ditertiobutyle (0,75 partie en poids)

composition organopolysiloxanique comprenant 70% en poids d'une huile diméthylpolysiloxanique dont les extrémités sont bloquées par des groupements triméthylsilyle (viscosité 300 cPo à 25°C) et 30% en poids d'une résine méthylpolysiloxanique constituée de motifs triméthylsiloxy et $SiO_2$ (1 partie en poids)

et du white spirit (1 partie en poids).

1.4. Charges:

Elles sont constituées par un mélange:

de fibres de verre de 0,8 mm de longueur commercialisées par la Société OWENS CORNING FIBERGLASS sous la référence P 177 B (1 partie en poids)

et de silice fondue commercialisée par la Société GLASROCK sous la référence GP 71 (2 parties en poids).

2. *Mélange des matériaux:*

On opère à l'aide d'un mélangeur de poudres HENSCHEL de 10 litres (vitesse de rotation: 1 800 tours/minute). Les opérations suivantes sont effectuées, chaque opération durant environ 3 minutes:

(i) on introduit dans le mélangeur 1 050 g de prépolymère puis on ajoute 120 g de mélange démoulant;

(ii) on coule ensuite sur la masse (i) 39 g de solution d'initiateur radicalaire;

(iii) puis on mélange les deux charges à l'ensemble (i) + (ii).

3. *Homogénéisation et broyage de la matière à mouler:*

On utilise pour homogénéiser l'ensemble (i) + (ii) + (iii) un malaxeur à double vis commercialisé par la Société CREUSOT-LOIRE et connu sous l'appellation "type RCB". La vis est logée dans un corps comprenant deux enveloppes cylindriques. Dans la première enveloppe, qui correspond à la zone d'alimentation du malaxeur, on fait circuler un fluide chauffé à 95°—100°C. Dans la seconde enveloppe, qui correspond à la zone de malaxage, on fait circuler un fluide chauffé à 100°—110°C. La vitesse de rotation des vis est de 12 tours/minute. Le temps de séjour moyen de la matière dans le malaxeur est de l'ordre de 3 à 5 minutes.

A la sortie du malaxeur, on recueille une masse qui, après refroidissement, est broyée de manière à obtenir des grains dont la granulométrie s'établit comme suivant:

| | | | |
|---|---|---|---|
| 60 | à | 100$\mu$: | 34 % |
| 100 | à | 500$\mu$: | 40,8% |
| 500 | à | 1 000$\mu$: | 7,1% |
| 1 000 | à | 2 000$\mu$: | 10,4% |
| 2 000 | à | 3 150$\mu$: | 7,7% |

L'écoulement de la poudre à mouler obtenue a été étudiée selon la norme définie par l'EPOXY MOLDING MATERIALS INSTITUTE (EMMI 1—66). Ce test consiste à mesurer, après moulage par transfert, la longueur d'une empreinte en spirale remplie par la poudre. L'écoulement de la poudre à mouler obtenue est de 35 à 40 inches (pression: 70 kg/cm2; température: 150°; chargement avec des pastilles froides de poudres ayant un poids de 20 g et un diamètre de 25 mm).

B/ *Moulages:*

1. Un essai de moulage par transfert a été réalisé sans introduire des composants électroniques dans les cavités du moule. Cet essai a pour but d'illustrer le bon comportement de la matière à mouler seule dans la cadre de la technique d'encapsulation.

Le moule utilisé est un module de redresseur du type TO 126 constitué de 2 barrettes à 28 cavités. Ce moule comprend:

un canal central d'alimentation permettant de distribuer la matière à mouler dans les cavités; sa longueur est de 125 mm et sa section de 13,5 mm2;

et de part et d'autre audit canal, 14 cavités de dimensions 11 × 7 × 3 mm (volume de 230 mm3) disposées les unes à côté des autres; chaque cavité est reliée un canal central par l'intermédiaire d'un orifice d'entrée ayant une section de 1,8 mm2.

La matière à mouler a été mise sous forme de pastilles ayant un diamètre de 25 mm et un poids de 15 g et ces pastilles sont préchauffées 50 secondes environ par chauffage sous une fréquence de 40 $MH_z$, pour obtenir une température à coeur de 90° à 100°C, avant d'être introduite dans le pot de transfert du moule.

Le remplissage des cavités par transfert de la matière à mouler s'effectue dans les conditions suivantes:

température du moule : 180°—185°C

pression du transfert : 40 kg/cm2

durée du moulage : 2 minutes

On note que les cavités du moule sont correctement remplies et qu'il n'y a pas ou très peu d'effets de bavures.

Les articles obtenus ont été ensuite recuits pendant 24 h à 200°C (sous pression atmosphérique). Ils possèdent les caractéristiques physico-mécaniques suivantes:

— résistance en flexion (norme ASTM D 790):

à température ambiante : 8,7 kg/mm2

à 200°C : 4,4 kg/mm2

— module en flexion (norme ASTM D 790):

à température ambiante : 1 470 kg/mm2

à 200°C : 1 210 kg/mm2

— coefficient de dilatation linéaire : 10 à $11.10^{-6}$ cm/cm/°C

2. On va décrire maintenant un essai d'encapsulation de ferrites à l'aide de la matière à mouler préparée au paragraphe A/.

Le moule utilisé comprend 2 canaux d'alimentation situés de part et d'autre du pot de transfert de la matière à mouler. Ces canaux ont chacun une longueur de 80 mm et une section de 8,75 mm2. Chaque canal alimente 5 cavités cylindriques disposées les unes à côté des autres et présentant chacune une longueur de 18,5 mm et un diamètre de 7,5 mm. Chaque cavité est reliée au canal d'alimentation par l'intermédiaire de 2 orifices d'entrée de section 1,2 mm2. Chaque cavité reçoit une ferrite ayant une longueur de 12 mm et un diamètre de 4 mm.

La matière à mouler a été mise sous forme de pastilles (diamètre: 25 mm; poids: 16 g) qui sont préchauffées 40 secondes environ par chauffage sous une fréquence de 40 $MH_z$ pour obtenir une température à coeur de 85° à 90°C.

Le remplissage par transfert des cavités renfermant les ferrites s'effectue dans les conditions suivantes:

température du moule : 185°C

pression du transfert : 45 kg/cm2

durée du moulage : 2 minutes

Après un recuit de 24 h à 200°C, les ferrites encapsulées ont été ensuite soumises à des cycles de chocs thermiques entre −55°C et +200°C; chaque cycle s'établit comme suivant:

10 minutes à −55°C

puis 10 minutes à température ambiante (20°—25°C)

puis 10 minutes à +200°C.

Aucune fissuration n'a été relevée après dix cycles.

**Revendications**

1. Compositions pour l'encapsulation de composants électroniques en utilisant les méthodes de moulage par trànsfert ou par injection constituées à partir:

(a) un prépolymère de bis-imide et de polyamine obtenu par chauffage de N,N'-4,4'-diphénylméthane bis-maléimide et du diamino-4,4'-diphénylméthane et présentant un point de ramollissement compris entre 50 et 120°C
(b) un initiateur de polymérisation radicalaire et
(c) des charges,

caractérisées en ce que l'évolution du module de la raideur complexe dudit prépolymère en fonction du temps, lorsqu'il est soumis à une opération de réticulation à 170°C, est telle qu'au bout de 5 minutes, ledit module est compris entre $3.10^4$ et $10^7$ N/m et qu'au bout de 15 minutes, il s'élève à des valeurs comprises entre $3.10^5$ et $3.10^7$ N/m, et que l'initiateur de polymérisation radicalaire est mis en oeuvre sous forme de suspension ou de solution dans une huile organopolysiloxanique ou dans une association comprenant une huile et une résine organopolysiloxanique.

2. Compositions selon la revendication 1, caractérisées en ce que l'initiateur est un peroxyde organique.

3. Compositions selon la revendication 1, caractérisées en ce que la proportion de charges représente de 10 à 75% de la composition moulable.

4. Compositions selon la revendication 1, caractérisées en ce qu'elles contiennnent, en outre, au moins un agent de démoulage.

5. Compositions selon la revendication 1, caractérisées en ce qu'elles sont préparées en incorporant en même temps dans le prépolymère à l'état solide, l'initiateur radicalaire en suspension ou en solution dans l'huile ou dans l'association huile/résine organopolysiloxanique, les charges et éventuellement l'agent de démoulage puis en homogénéisant l'ensemble par malaxage.

6. Procédé d'encapsulation d'au moins un composant electronique à l'aide d'une composition selon un des revendications 1 à 5, caractérisé en ce que la matière à mouler est préparée par enchaînement des étapes suivantes:

en opérant dans un mélangeur à poudre classique, on mélange le prépolymère avec la suspension ou la solution initiateur/composé organosilicique en coulant ladite suspension ou solution sur le prépolymère à l'état solide ou sur le mélange, préparé préalablement, du prépolymère et de l'agent de démoulage, puis on incorpore les charges à l'ensemble de la masse obtenue;

on procède ensuite à l'homogénéisation de la matière à mouler en opérant dans un malaxeur à vis extrudeuse.

**Patentansprüche**

1. Zusammensetzungen zur Einkapselung von elektronischen Bauteilen unter Verwendung von Spritzpreß- oder Spritzgieß-methoden, gebildet aus:

(a) einem Prepolymeren aus Bisimid und Polyamin, erhalten durch Erhitzen von N,N'-4,4'-Diphenylmethan-bismaleimid und 4,4'-Diamino-diphenylmethan, das einen Erweichungspunkt zwischen 50 und 120°C aufweist,
(b) einem radikalischen Polymerisationsinitiator und
(c) Füllstoffen,

dadurch gekennzeichnet, daß die Entwicklung des Moduls der komplexen Steifheit dieses Prepolymeren als Funktion der Zeit, wenn es einer Vernetzungsoperation bei 170°C unterworfen wird, derart est, daß am Ende von 5 Minuten dieser Modul zwischen $3.10^4$ und $10^7$ N/m ist und daß am Ende von 15 Minuten er sich auf Werte zwischen $3.10^5$ und $3.10^7$ N/m steigert und daß der radikalische Polymerisationsinitiator in Form einer Suspension oder Lösung in einem Organopolysiloxanöl oder in einer Zusammensetzung, enthaltend ein öl und ein Organopolysiloxanharz, eingesetzt wird.

2. Zusammensetzungen gemäß Anspruch 1, dadurch gekennzeichnet, daß der Initiator ein organisches Peroxid ist.

3. Zusammensetzungen gemäß Anspruch 1, dadurch gekennzeichnet, daß die Menge an Füllstoffen 10 bis 75% der verformbaren Zusammensetzung beträgt.

4. Zusammensetzungen gemäß Anspruch 1, dadurch gekennzeichnet, daß sie außerdem wenigstens ein Entformungsmittel enthalten.

5. Zusammensetzungen gemäß Anspruch 1, dadurch gekennzeichnet, daß sie hergestellt sind, indem gleichzeitig in das Prepolymere in festem Zustand der radikalische Initiator in Suspension oder in Lösung in dem öl oder in der Zusammensetzung öl/Organopolysiloxanharz, die Füllstoffe und gegebenenfalls das Entformungsmittel eingebracht werden und indem dann das Ganze durch Kneten homogenisiert wird.

6. Verfahren zur Einkapselung wenigstens eines elektronischen Bauteils mittels einer Zusammensetzung gemäß einem der Ansprüche 1 bis 5, dadurch gekennzeichnet, daß das zu verformende Material hergestellt wird durch Aufeinanderfolge der folgenden Stufen:

indem in einem klassischen Pulvermischer gearbeitet wird, vermischt man das Prepolymere mit der Suspension oder Lösung Initiator/Organosiliciumverbindung, wobei diese Suspension oder Lösung auf das Prepolymere in festem Zustand oder auf das vorher hergestellte Gemisch des Prepolymeren und des Entformungsmittels gegossen wird, und daß man dann die Füllstoffe der Gesamtheit der erhaltenen Masse einverleibt;

man schreitet dann zur Homogenisierung des zu verformenden Materials, indem in einem Schneckenmischer gearbeitet wird.

## Claims

1. Compositions for the encapsulation of electronic components using transfer moulding or injection moulding methods, the compositions being made up from:

(a) a prepolymer of a bis-imide and a polyamine, obtained by heating N,N'-4,4'-diphenylmethane bis-maleimide and 4,4'-diamino-diphenylmethane, and having a softening point of between 50 and 120°C

(b) a radical polymerisation initiator and

(c) fillers,

characterised in that the variation of the complex modulus of rigidity of the said prepolymer as a function of time, when the prepolymer is subjected to a crosslinking treatment at 170°C, is such that after 5 minutes the said modulus is between $3.10^4$ and $10^7$ N/m and that after 15 minutes it has risen to values of between $3.10^5$ and $3.10^7$ N/m, and that the radical polymerisation initiator is employed in the form of a suspension or solution in an organopolysiloxane oil or in a combination comprising an oil and an organopolysiloxane resin.

2. Compositions according to Claim 1, characterised in that the initiator is an organic peroxide.

3. Compositions according to Claim 1, characterised in that the proportion of fillers represents from 10 to 75% of the mouldable composition.

4. Compositions according to Claim 1, characterised in that they moreover contain at least one demoulding agent.

5. Compositions according to Claim 1, characterised in that they are prepared by simultaneously incorporating into the prepolymer, which is in the solid state, the radical initiator in suspension or in solution in the oil or in the combination of oil and organopolysiloxane resin, the fillers and, where appropriate, the demoulding agent, and then homogenising the whole by malaxating.

6. Process for encapsulating at least one electronic component with the aid of a composition according to one of Claims 1 to 5, characterised in that the moulding material is prepared by successively carrying out the following steps:

using a conventional powder mixer, the prepolymer is mixed with the suspension or solution of initiator organosilicon compound by pouring the said suspension or solution over the prepolymer which is in the solid state or over the previously prepared mixture of the prepolymer and the demoulding agent, after which the fillers are incorporated into the whole of the mass obtained and

thereafter the moulding material is homogenised, using an extrusion screw malaxator.